# EUROPEAN PATENT APPLICATION

(11) **EP 4 745 826 A1**
(43) Date of publication of application: **20.05.2026**
(21) Application number: 24275125.3
(22) Date of filing: 15.11.2024
(51) Int. Cl.: G06F 30/27, G06N 20/00, G06F 18/24, H04B 7/185, H04W 84/06

(54) **RF EMITTER GROUPING**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

Methods, apparatus and systems are described configured to: obtain RF data at a remote node of a system, wherein the RF data is transmitted by a RF emitter; process the obtained RF data at the remote node using a trained RF emitter profiling model to perform feature extraction; determine whether the respective RF emitter is a known emitter; provide data relating to the RF emitter to a central node of the system in the event that the RF emitter is not a known emitter; and provide data relating to the RF emitter to a local database at the remote node in the event that the RF emitter is a known emitter.

## Description

### FIELD

The present invention relates to radio frequency, RF, emitters and receivers and to systems and methods incorporating RF emitters and receivers.

### BACKGROUND

RF emitters may be grouped based on characteristics of RF signals received from such emitters. This may be used, for example, to seek to distinguish an RF emitter from similar or apparently identical RF emitters. There remains a need for further developments in this field.

### SUMMARY

According to a first aspect of the present invention, there is provided a method comprising: obtaining radio frequency, RF, data at a remote node of a system, wherein the RF data is transmitted by a RF emitter; processing the obtained RF data at the remote node using a trained RF emitter profiling model (e.g. a foundation model) to perform feature extraction; determining whether the respective RF emitter is a known emitter; providing data relating to the RF emitter to a central node (e.g. a ground node) of the system in the event that the RF emitter is not a known emitter; and providing data relating to the RF emitter to a local database at the remote node in the event that the RF emitter is a known emitter. The method may be performed at a remote node. The remote node may be one of a plurality of remote nodes of the system. The remote node may be satellite-based node (e.g. in space, such as in a low-earth orbit). An RF emitter may be "known emitter" if that emitter is included in the training of the RF emitter profiling model.

The method may further comprise receiving (e.g. from a central node, such as a node that has more/sufficient resources, such as computing, storage and/or power resources) updates to the RF emitter profiling model. The updates may be in response, at least in part, to said data relating to the RF emitter provided to the central node. The updates may include updated weights of the model.

In some example embodiments, processing the obtained RF data comprises generating an RF fingerprint for the respective emitter. The RF fingerprint may be generated using a foundation model (or some other model) that is trained for the extraction of the RF fingerprint from received RF data, including, for example, from previously unknown and/or previously unseen RF emitters. Such a model may generalise well to new, previously unseen RF emitters.

The method may further comprise assigning an identifier to the RF emitter in the event that the RF emitter in not a known emitter, wherein the data provided to the central node includes said identifier.

In some example embodiments, the data relating to the RF emitter provided to the central node includes some or all of the obtained RF data.

The method may further comprise using a classifier to identify the RF emitter in the event that the RF emitter is a known emitter. The method may further comprise updating the classifier based, at least in part, on the data relating to the RF emitter provided to said local database.

In some example embodiments, obtaining said RF data comprises receiving in-phase and quadrature data from the RF emitter (or some other raw, received RF emissions).

In some example embodiments, the RF emitter profiling model comprises a plurality of neural networks or deep learning models.

According to a second aspect of the present invention, there is provided a method comprising: receiving, at a central node of a system from a remote node of the system, data relating to an RF emitter that is not known to a RF emitter profiling model deployed at the remote node; adding some or all of the received data to a training set for the RF emitter profiling model; updating the RF emitter profiling model using said training set; and providing an update to the RF emitter profiling model to the remote node. The method may be performed at a central node, such as a ground station or some other more capable node (e.g. an in-space node with more computing/memory/power resources than the remote node(s)). The remote node may be one of a plurality of remote nodes of the system. The remote node may be a satellite-based node (e.g. in space, such as in a low-earth orbit).

In some example embodiments, the update to the RF emitter profiling model provided to the remote node comprises updated weights of the RF emitter profiling model.

In some example embodiments, the data relating to the RF emitter received at the central node includes an identifier to the RF emitter as assigned by the remote node. The received data added to said training data may include said identifier.

The RF emitter profile model may be updated periodically.

In some example embodiments, the data relating to the RF emitter received at the central node from the remote node includes some or all of RF data (e.g. raw I-Q data) obtained by the remote node relating to said RF emitter.

In some example embodiments, the RF emitter profiling model comprises a plurality of neural networks or deep learning models (e.g. having a plurality of convolutional neural network, CNN, layers).

According to a third aspect of the present invention, there is provided a remote node of a system, the remote node comprising: a first module for obtaining radio frequency, RF, data transmitted by a RF emitter; a control module for processing the obtained RF data at the remote node using a trained RF emitter profiling model (e.g. a foundation model) to perform feature extraction and to determine whether the respective RF emitter is a known emitter; a local database for storing data relating to the RF emitter in the event that the RF emitter is a known emitter; and a first output for providing data relating to the RF emitter to a central node of the system (e.g. a ground node) in the event that the RF emitter is not a known emitter. The remote node may be one of a plurality of remote nodes of the system. The remote node may be satellite-based node (e.g. in space, such as in a low-earth orbit). An RF emitter may be "known emitter" if that emitter is included in the training of the RF emitter profiling model.

The remote node may be configured to receive updates to the RF emitter profiling model. The updates may be in response, at least in part, to said data relating to the RF emitter provided to the central node. The updates may include updated weights of the model.

In some example embodiments, processing the obtained RF data comprises generating an RF fingerprint for the respective emitter. The RF fingerprint may be generated using a foundation model (or some other model) that is trained for the extraction of the RF fingerprint from received RF data, including, for example, from previously unknown and/or previously unseen RF emitters. Such a model may generalise well to new, previously unseen RF emitters.

The control module may be configured to assign an identifier to the RF emitter in the event that the RF emitter in not a known emitter, wherein the data provided to the central node includes said identifier.

A classifier may be provided to identify the RF emitter in the event that the RF emitter is a known emitter. The classifier may be updated, from time-to-time, based, at least in part, on the data relating to the RF emitter provided to said local database.

In some example embodiments, the RF emitter profiling model comprises a plurality of neural networks or deep learning models.

According to a fourth aspect of the present invention, there is provided a central node of a system, the central node comprising: a first input for receiving, from a remote node of the system, data relating to an RF emitter that is not known to a RF emitter profiling model deployed at the remote node; a control module for adding some or all of the received data to a training set for the RF emitter profiling model and updating the RF emitter profiling model using said training set; and an output for providing an update to the RF emitter profiling model to the remote node. The remote node may be one of a plurality of remote nodes of the system. The remote node may be a satellite-based node (e.g. in space, such as in a low-earth orbit).

In some example embodiments, the update to the RF emitter profiling model provided to the remote node comprises updated weights of the RF emitter profiling model.

In some example embodiments, the data relating to the RF emitter received at the central node includes an identifier to the RF emitter as assigned by the remote node. The received data added to said training data may include said identifier.

The RF emitter profile model may be updated periodically.

In some example embodiments, the data relating to the RF emitter received at the central node from the remote node includes some or all of RF data (e.g. raw I-Q data) obtained by the remote node relating to said RF emitter.

In some example embodiments, the RF emitter profiling model comprises a plurality of neural networks or deep learning models (e.g. having a plurality of convolutional neural network, CNN, layers).

According to a fifth aspect of the present invention, there is provided a system comprising a central node as described above with reference to the fourth aspect and one or more remote nodes as described above with reference to the third aspect. The system may further comprise one or more RF emitters. At least some of the remote node(s) may be satellite-based nodes.

According to a sixth of the present invention, there is provided computer-readable instructions which, when executed by a computing apparatus, cause the computing apparatus to perform (at least) any method as described herein (including the methods of the first and second aspects described above).

According to a seventh aspect of the present invention, there is provided a computer-readable medium (such as a non-transitory computer-readable medium) comprising program instructions stored thereon for performing (at least) any method as described herein (including the methods of the first and second aspects described above).

According to an eighth of the present invention, there is provided an apparatus comprising: at least one processor; and at least one memory including computer program code which, when executed by the at least one processor, causes the apparatus to perform (at least) any method as described herein (including the methods of the first and second aspects described above).

### BRIEF DESCRIPTION OF THE FIGURES

Embodiments of the invention will now be described by way of example only with reference to the figures, in which:
Figure 1 is a block diagram of a system in accordance with an example embodiment;
Figure 2 is a flow chart showing an example operation of the circuit of Figure 1;
Figure 3 shows an RF transmitter circuit;
Figures 4 to 6 are block diagrams of systems in accordance with example embodiments;
Figure 7 is a plot showing data generated in accordance with an example embodiment;
Figure 8 is a block diagram of a system in accordance with an example embodiment;
Figure 9 is a flow chart showing functionality in accordance with an example embodiment;
Figure 10 is a block diagram of a system in accordance with an example embodiment;
Figure 11 is a flow chart showing functionality in accordance with an example embodiment;
Figure 12 is a message flow sequence in accordance with an example embodiment;
Figures 13 and 14 are flow charts showing functionality in accordance with example embodiments;
Figures 15 to 19 are block diagrams of systems in accordance with example embodiments;
Figures 20 and 21 are flow charts showing functionality in accordance with example embodiments;
Figure 22 is a block diagram of a system in accordance with an example embodiment;
Figure 23 is a message flow sequence in accordance with an example embodiment;
Figure 24 shows a neural network used in some example embodiments; and
Figure 25 is a block diagram of a system in accordance with an example embodiment.

### DETAILED DESCRIPTION

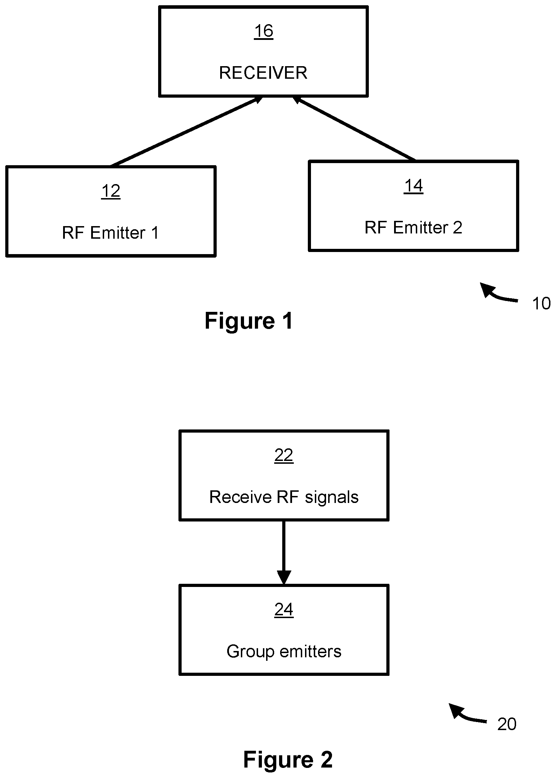

Figure 1 is a block diagram of a system, indicated generally by the reference numeral 10, in accordance with an example embodiment. The system 10 comprises a first radio frequency, RF, emitter 12, a second RF emitter 14 and a receiver 16. The receiver 16 receives RF signals from both the first and second RF emitters. The RF emitters may, for example, be devices such as radios, radar devices, transponders, jamming devices or the like.

Figure 2 is a flow chart, indicated generally by the reference numeral 20, showing an example operation of the circuit of Figure 1. The flow chart 20 may be implemented at the receiver 16.

The flow chart 20 starts at step 22, where RF signals are received (for example from the first RF emitter 12 and/or from the second RF emitter 14); in many circumstances, however, the receiver would receive RF signals from a large number of RF emitters, which emitters may change over time.

As step 24, emitters are grouped based on characteristics of the received RF signals, for example to enable individual devices or groups of devices to be identified and/or tracked.

By way of example, signals caused by hardware imperfections or other differences between devices can enable otherwise similar RF emitters to be distinguished; indeed, apparently identical RF emitters can be distinguished in this way. Such differences can collectively form a radio frequency fingerprint (RFF) that the receiver 16 can be programmed to identify (or at least distinguish) in order to implement to step 24 of the flow chart 20. Note that such differences are generally hard to spoof and hard to conceal.

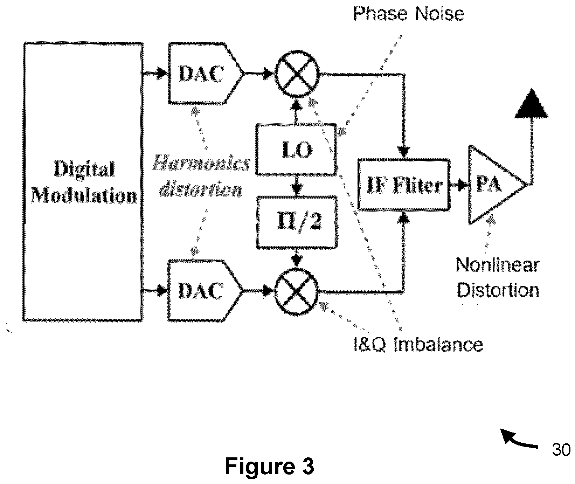

Figure 3 shows an RF transmitter circuit, indicated generally by the reference numeral 30. The RF transmitter may be one of the RF emitters 12 and 14 described above.

The RF transmitter circuit 30 includes many imperfections and many sources of noise. By way of example, the RF transmitter circuit 30 includes digital-to-analog converters (DACs) that may introduce harmonic distortion, a pair of mixers that may suffer from an I/Q imbalance, a local oscillator that may introduce phase noise and a power amplifier that may introduce non-linear distortion. If such imperfections are unique to individual instances of the RF transmitter circuit 30, then those characteristics can potentially be used to distinguish a transmitter from other similar transmitters.

It should be noted that the sources of imperfections and noise described above with reference to Figure 3 are provided by way of example only. Other sources of imperfections and noise may exist in addition to, or instead of, one or more of the sources described above.

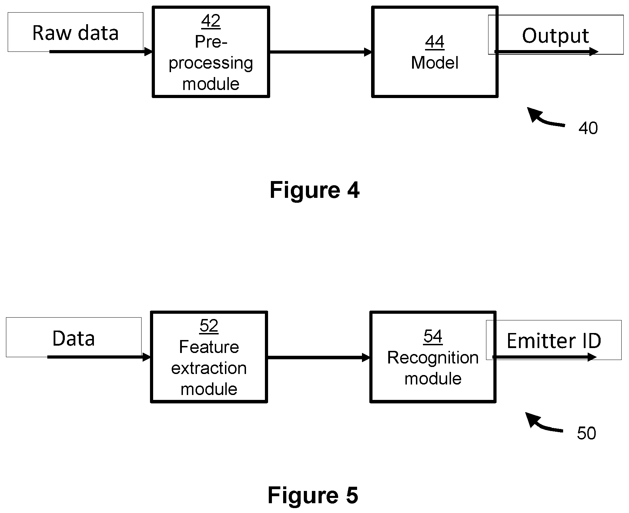

Figure 4 is a block diagram of a system, indicated generally by the reference numeral 40, in accordance with an example embodiment. The system 40 comprises a pre-processing module 42 and a model 44.

The pre-processing module 42 receives raw data relating to an RF emitter. The raw data may, for example, comprise in-phase and quadrature data relating to the RF emitter and/or some other raw, received RF emissions. Examples of raw data that might be provided are described above with reference to Figure 3.

The model 44 is used to convert the pre-processed raw data into an output. The model 44 may implement a specific emitter identification (SEI) module. SEI modules are typically hand-crafted and are therefore slow and difficult to deploy. The model 44 may be developed, at least in part, using machine learning (ML) principles in which RFF for SEI are learned from real signals. This enables multi-purpose SEIs to be generated, rather than very specific, inflexible models.

The model 44 may, for example, be a foundation model (or some similar model) that is trained for the robust extraction of RF fingerprints from received RF data including from unknown and/or previously unseen RF emitters. The model 44 can thereby generalise well to new (i.e. previously unseen) RF emitters.

Figure 5 is a block diagram of a system, indicated generally by the reference numeral 50, in accordance with an example embodiment. The system 50 is an example implementation of the model 44 described above. The system 50 comprises a feature extraction module 52 for learning/extracting emitter RF fingerprints and a recognition module 54.

The feature extraction module 52 receives data, which may be the data output by the pre-processor module 42 described above. The feature extraction module 52 may be trained to identify characteristics of RF signals transmitted by example RF emitters and may provide an RF fingerprint to the recognition module 54.

The recognition module 54 may match the output of the feature extraction module 52 to an emitter identifier (Emitter ID) of a particular RF em itter.

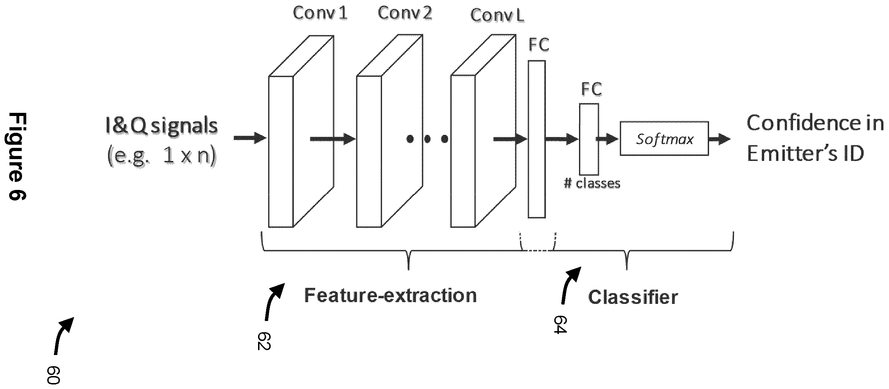

Figure 6 is a block diagram of a system, indicated generally by the reference numeral 60, in accordance with an example embodiment. The system 60 includes a feature extraction section 62 (that may be used to implement the feature extraction module 52 described above) and a classifier 64 (that may be used to implement the recognition module 54 described above).

The feature extraction module 62 includes a number of layers in the form of a deep learning model, such as a convolution neural network (CNN) (L layers - Conv1, Conv2...ConvL - are shown in FIG. 6 by way of example). The CNN layers may, for example, be used to extract features from transmitted RF signals. The layers of the feature extraction module 62 are trainable using machine learning principles. Other network architectures, such as transformer, recurrent neural network (RNN), multilayer perceptron (MLP) etc. could be used instead of the aforementioned CNN.

The classifier 64 takes the output of the feature extraction module 62 (e.g. a radio frequency fingerprint) and generates an indication of the most likely identifier of the respective RF transmitter. Note that the provision of the classifier 64 is not an essential feature of all example embodiments. For example, a system may be provided that can distinguish individual emitters, without actually identifying those emitters.

When updating the system 60 (for example to identify a new RF emitter), the feature extraction module typically does not need to be updated; it is often sufficient to simply update the classifier 64, thereby reducing the amount of training and the quantity of neural network parameters that need to be updated.

It should be noted that the system 60 is provided by way of example only. Many other machine learning/deep learning models and neural network architectures may be used.

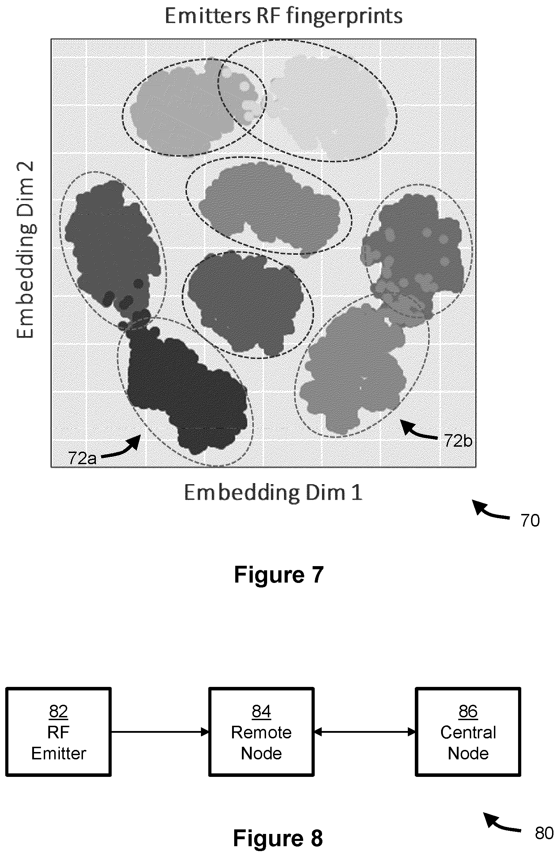

Figure 7 is a plot, indicated generally by the reference numeral 70, showing data generated in accordance with an example embodiment. The plot 70 shows example outputs of the feature extraction module 62 expressed as a two-dimensional plot. The plots show multiple signals from particular RF emitters grouped using dotted lines. For example, signals 72a are from one RF emitter and signals 72b are from a second RF emitter.

The plot 70 shows the results of t-distributed stochastic neighbor embedding (t-SNE) applied to the learnt higher dimensional embeddings (e.g. of dimensions exceeding 100) from the processed RF signal (i.e. capturing the emitter's RF fingerprint). However, this is purely for reducing the dimensionality of the RFF and visualising it in 2D and is provided by way of example only.

The plot 70 demonstrates that, in principle, the model used to generate the plot can be used to recognise individual RF emitters from received RF signals.

Figure 8 is a block diagram of a system, indicated generally by the reference numeral 80, in accordance with an example embodiment. The system 80 comprises an RF emitter 82, a remote node 84 and a central node 86. The RF emitter 82 may be one of a plurality of RF emitters that the remote and/or central nodes may seek to identify or distinguish between.

As discussed further below, the remote node 84 may be a satellite node, for example implemented on a satellite such as a low earth orbit (LEO) satellite. The central node 86 may be a ground station provided on the Earth's surface that is in communication with the remote node/satellite 84.

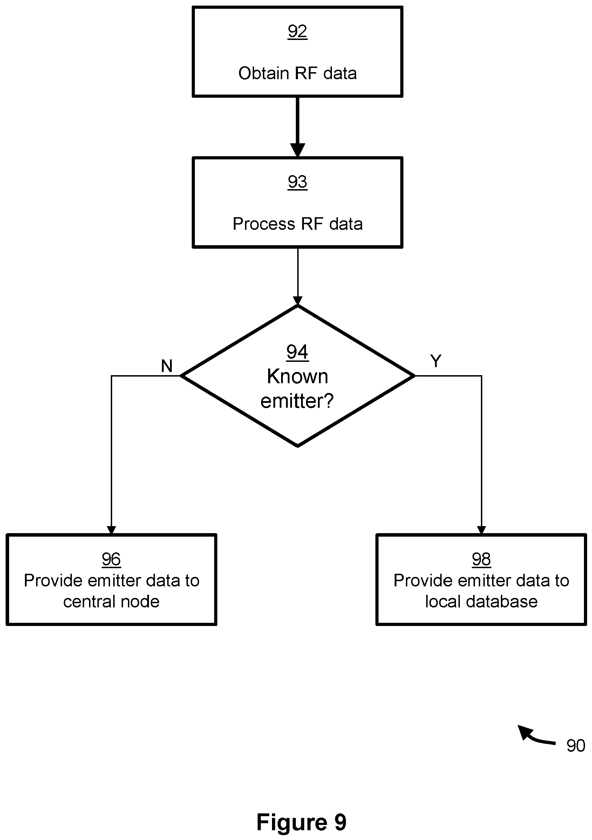

Figure 9 is a flow chart, indicated generally by the reference numeral 90, showing functionality in accordance with an example embodiment. The flow chart 90 may be at a remote node of a system (such as the remote node 84 of the system 80).

The flow chart 90 starts at step 92, wherein RF data is obtained (e.g. received) at a remote node of a system (such as the remote node 84 of the system 80). The RF data is transmitted by one or more RF emitters (such as the RF emitter 82 of the system 80). Obtaining the RF data may comprise receiving in-phase and quadrature data (or some other raw, received RF emissions) from the respective RF emitter(s), as discussed above.

At step 93, the RF data obtained in step 92 is processed (at the remote node 84) using a trained RF emitter profiling model to perform feature extraction. The trained RF emitter profiling model may be a generalisation model (sometimes referred to as a foundation model) that learns the RFF of emitters and can be applied to previously unseen emitters. By way of example, processing the RF data may include generating an RF fingerprint for the RF emitter that transmitted the RF data. The step 93 may be implemented by the feature extraction modules 52 or 62 described above.

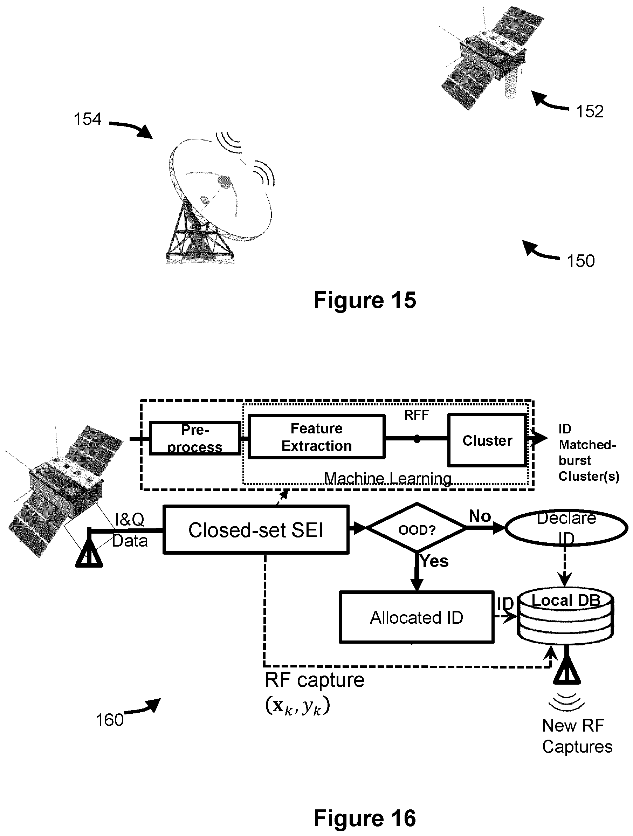

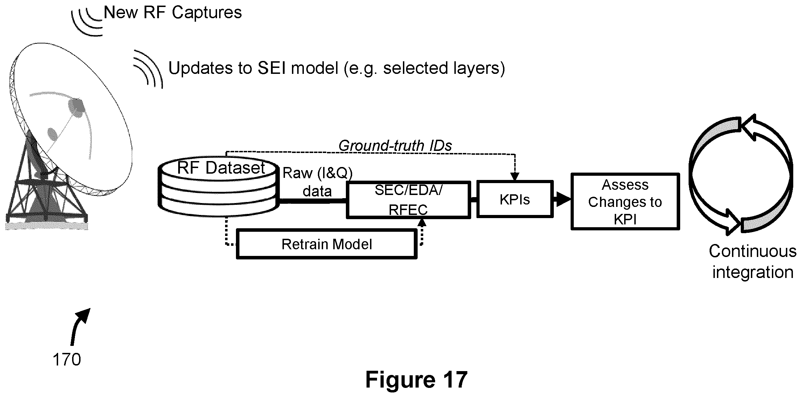

At step 94 a determination is made regarding whether the respective RF emitter is a known emitter. For example, step 94 may include determining whether the respective RF emitter is included in the training data for an RF emitter profiling model (such as the model 105 discussed below, or the models shown in Figures 16 and 17 discussed below).

If the RF emitter is not known, then the flow chart 90 moves to step 96, where data relating to the RF emitter is provided to a central node (e.g. the central node 86 of the system 80, such as a ground node). The data relating to the RF emitter may be used in updating the relevant model. As discussed further below, an updated RF emitter profile may be provided as a result of data relating to the previously unknown RF emitter being provided to the central node. Note that, in some example embodiments, only selected parameters of the classifier (e.g. neural network weights) are updated to include the recognition of the previously unknown/unseen RF emitter, rather than the entire model.

Alternatively, if the emitter is known, then the flow chart 90 moves to step 98, where data relating to the RF emitter is provided to a local database at the remote node.

A recognition module (such as the module 54 or the classifier 64) may be used to identify the RF emitter in the event that the RF emitter is a known emitter. Moreover, the classifier may be updated based, at least in part, on the data relating to the RF emitter provided to the local data in the step 98. Note that, in some example embodiments, only selected parameters of the classifier (e.g. neural network weights).

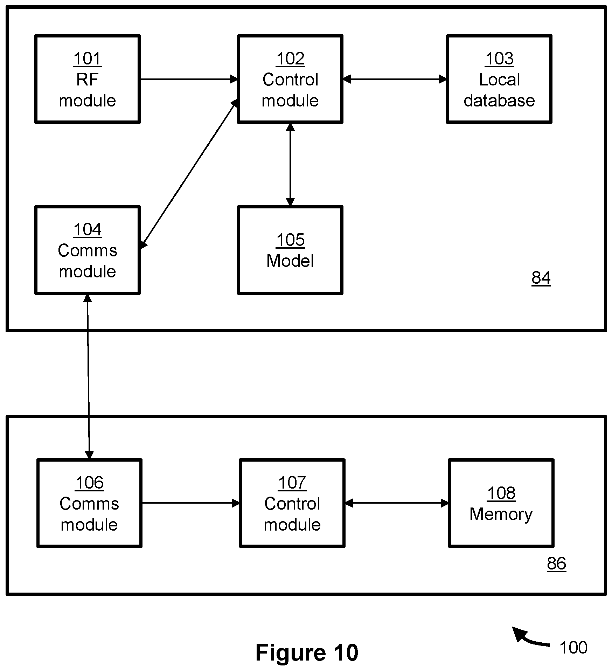

Figure 10 is a block diagram of a system, indicated generally by the reference numeral 100, in accordance with an example embodiment. The system 100 shows details of example implementations of the remote node 84 and central node 86 of the system 80 described above. As discussed above, the remote node 84 may be a satellite-based node.

The remote node 84 comprises an RF module 101, a control module 102, a local database 104, a communication module 104 and a model 105. As discussed above, the model 105 may be an RF emitter profiling model comprising a plurality of neural network or deep learning models (e.g. convolutional neural networks (CNN) layers or some other neural network or deep learning architecture).

The RF module 101 obtains (e.g. receives) radio frequency, RF, data transmitted by a RF emitter (such as the RF emitter 82 described above).

The control module 102 is used to process the obtained RF data using a trained RF emitter profiling model 105 (e.g. a foundation model) to perform feature extraction and to determine whether the respective RF emitter is a known emitter (e.g. included in the training of the model 105). The local database 103 is used to store data relating to the RF emitter (in particular in the event that the RF emitter is a known emitter).

The communication module 104 has an output for providing data relating to the RF emitter to the central node 86 (in particularly, in the event that the RF emitter is not a known emitter).

The central node 86 comprises a communication module 106, a control module 107 and memory 108.

The communication module 106 of the central node has an input for receiving, from a communication node 104 of the remote node 84, data relating to an RF emitter from the communication node 104 of the remote node 84. In particular, data may be provided to the communication module 106 in the event that RF emitter is not known to a RF emitter profiling model deployed at the remote node.

The control module 107 may be used to add some or all of the received data to a training set for the RF emitter profiling model and updating the RF emitter profiling model using said training set.

The communication module 106 also has an output for providing an update to the RF emitter profiling model to the remote node (e.g. updated neural network parameters).

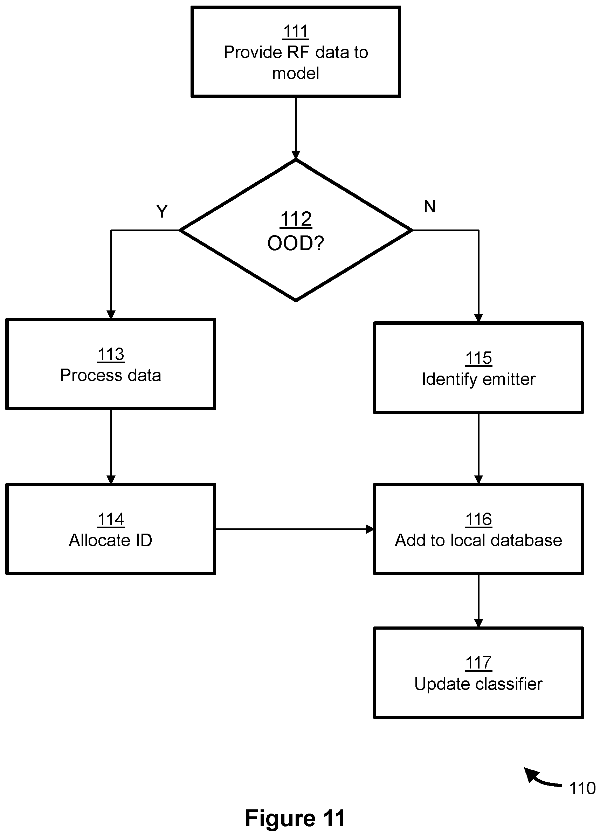

Figure 11 is a flow chart, indicated generally by the reference numeral 110, showing functionality in accordance with an example embodiment. The flow chart 110 may be implemented at the remote node 84 (e.g. at the control module 102).

The flow chart 110 starts at step 111, where RF data is provided to a model (e.g. the model 105). The RF data may include in-phase and quadrature data (I, Q data), as discussed above.

At step 112, an out-of-distribution (OOD) determination is made. This determines whether the model 105 is able to handle the data obtained in step 111 (e.g. is the data from a previously considered or processed emitter). The step 112 is an example implementation of the step 94 of the flow chart 90 described above.

If the RF data is deemed to be out-of-distribution, the flow chart moves to step 113; otherwise the flow chart moves to step 115.

At step 113, the RF data is processed (e.g. filtered). The data (e.g. as processed in step 113) may also be provided to the central node, as discussed above in the step 96 of the flow chart 90.

At step 114 an identifier is allocated to the (unknown/previously unseen) RF emitter. The data provided to the central node in step 96 of the algorithm 90 may include said identifier. The data is also provided to the local database in step 116 of the flow chart 110.

At step 115, the emitter is identified based on the RF data provided to the model in step 111. Data relating to the identified emitter is added to the local database in step 116 (thereby implementing step 98 of the flow chart 90). The updated local database can then be used to update the classifier so that the local classifier can be updated based on new RF data received from known emitter(s).

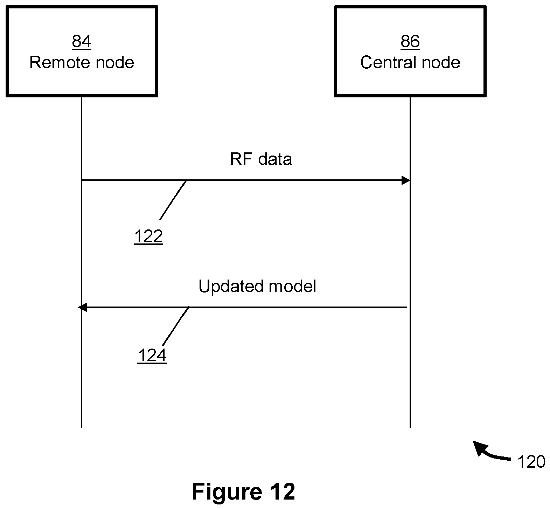

Figure 12 is a message flow sequence, indicated generally by the reference numeral 120, in accordance with an example embodiment. The sequence 120 shows message transferred between the remote mode 84 and the central node 86 (e.g. using the communication modules 104 and 106 described above).

The sequence 120 starts at step 122, where data derived from RF data obtained at the remote node is provided to the central node. The data may include some or all of the RF data; alternatively, the data may be processed in some way.

At step 124, the central node 86 provide updates to the RF emitter profiling model to the remote node 84 (e.g. including updated weights of the model). The updated RF emitter profiling model may be provided in response, at least in part, to said data relating to the RF emitter provided to the central node in the step 122. The RF emitter profiling model may comprise a plurality of neural networks or deep learning models (e.g. convolutional network (CNN) layers; such layers can be used to extract features from transmitted RF signals, as discussed above.

In this way, training can be performed at the central node 86, with model parameters being transmitted from the central node to the remote node so that the model can be updated at the remote node. If the central node has more resources than the remote node (e.g. more computing and/or memory and/or power resources), this can be a relatively efficient solution.

Note that when updating the model to account for data from new (e.g. previously unseen) RF emitters, it may only be necessary to implement some of the layers of a model (such as the classifier); for example, it may not be necessary to update the feature extraction module. Thus, the amount of data that needs to be sent from the central node 86 to the remote node 84 in the message 124 may be quite limited. This can be useful, since the bandwidth available for communications to the remote node can sometimes be more limited than the bandwidth available for communications from the remote node.

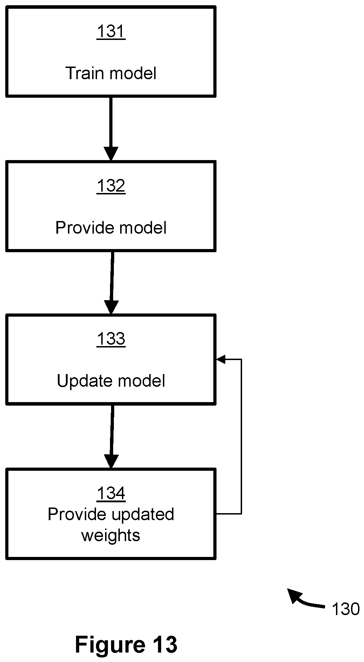

Figure 13 is a flow chart, indicated generally by the reference numeral 130, showing functionality in accordance with an example embodiment. The flow chart 130 may be implemented at the central node 86 (e.g. at the control module 107 of the central node).

The flow chart 130 starts at step 131, where a model is trained (e.g. by updating weights of a neural network). The model may be trained based on initial RF data. Note that the step 131 may include modifying a generic model (e.g. a foundation model) based on real data.

At step 132, the trained model is provided to one or more remote nodes (such as the remote node 84). The model can then be deployed (e.g. used in the flow charts 90 and 110 described above).

At step 133, the model is updated based on RF data obtained from one or more remote nodes. From time-to-time, updated weights of the model are provided to the remote node(s) in step 134. Steps 133 and 134 can be repeated as required.

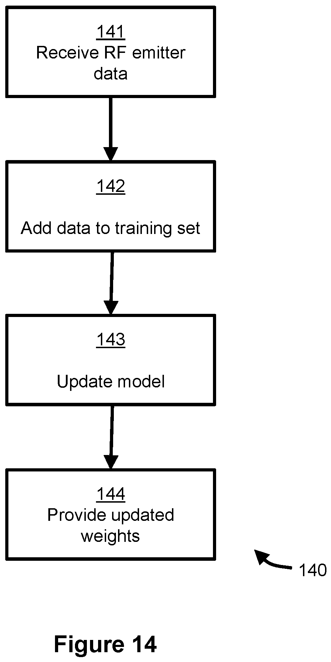

Figure 14 is a flow chart, indicated generally by the reference numeral 140, showing functionality in accordance with an example embodiment. The flow chart 140 may be implemented at the central node 86 and can be used to implement steps 133 and 134 of the flow chart 130 described above.

At step 141, data relating to an RF emitter that is not known to a RF emitter profiling model deployed at the remote node is received at a central node (implementing step 96 of the flow chart 90 and/or message 122 of flow chart 120). The data relating to the RF emitter received in step 141 may include some or all of the RF data obtained by the remote node relating to said RF emitter. The data may be raw received emissions from the RF emitter (e.g. raw I-Q data) or data that is processed in some way (e.g. filtered).

At step 142, some or all of the data received in one or more instances of the step 141 is added to a training set for the RF emitter profiling model. The data relating to the RF emitter received in step 141 and added to the training data in step 142 may include an identifier of the RF emitter as assigned by the remote node (e.g. in step 114 of the flow chart 110).

The RF emitter profiling model is updated in step 143 using the training set. Thus, step 143 is an example implementation of the step 133 of the flow chart 130. As discussed above, the RF emitter profiling model may include a number of convolutional neural network layers, at least some of which are trainable; alternative implementations of the RF emitter profiling model are also possible, as discussed above.

The RF emitter profile model may be updated in step 143 periodically (e.g. infrequently). The rate at which the RF emitter profile model is updated could, for example, be dependent on the availability of a communication link (e.g. between the communication modules described above). By way of example, the RF emitter profile model may be updated each time a satellite housing the remote node returns to a field-of-view of the central node (e.g. approximately every 1.5 hours).

Finally, at step 144, an update to the RF emitter profiling model is provided to the remote node (e.g. by providing updated model weights). Thus, step 144 is an example implementation of the step 134 of the flow chart 130.

Figure 15 is a block diagram of a system, indicated generally by the reference numeral 150, in accordance with an example embodiment. The system 150 comprises a satellite 152 and a ground station 154 that is in two-way communication with the satellite. The satellite 152 may provide RF data (or processed RF data) to the ground station 154 so that the ground station can update the model that is being implemented at the satellite. The ground station may provide updated parameters (e.g. updated selected layers of a neural network, such as updated classifier parameters) to the satellite 152.

Figure 16 is a block diagram of a system, indicated generally by the reference numeral 160, in accordance with an example embodiment. The system 160 shows elements that may be implemented at the satellite 152 of the system 150. In particular, the system 160 shows elements that may be used to implement the algorithm 110 described above.

Figure 17 is a block diagram of a system, indicated generally by the reference numeral 170, in accordance with an example embodiment. The system 170 shows elements that may be implemented at the ground station 154 of the system 150. In particular, the system 170 shows elements that may be used to implement the algorithm 140 described above.

In the system 150, the satellite 152 may be in space (e.g. in a geo-stationary orbit, or some other orbit, such as a low earth orbit (LEO)). In the system 80 described above, the remote node 84 may be implemented at the satellite 152 and the central node 86 may be implemented at the ground node 154. However, alternative configurations are possible.

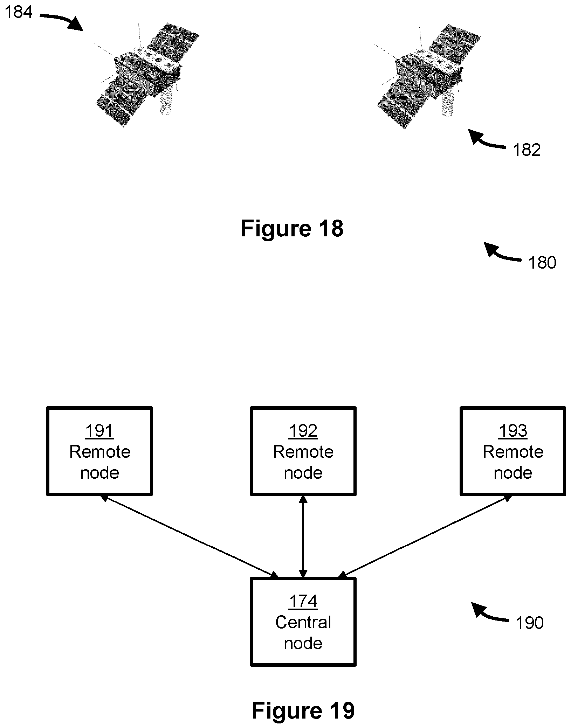

Figure 18 is a block diagram of a system, indicated generally by the reference numeral 180, in accordance with an example embodiment. The system 180 comprises a first satellite 182 and a second satellite 184 that is in two-way communication with the first satellite. The first and second satellites may both be in space (e.g. in a geo-stationary orbit, or some other orbit, such as a low earth orbit (LEO)). In the system 80 described above, the remote node 84 may be implemented at the first satellite 182 and the central node 86 may be implemented at the second satellite 184. The second satellite may, for example, be more capable than the first satellite in some way (e.g. having more storage and/or more computing power and/or more power resources).

The remote node 84 of the system 80 may be one of a plurality of remote nodes. By way of example, Figure 19 is a block diagram of a system, indicated generally by the reference numeral 190, in accordance with an example embodiment. The system 190 has a first remote node 191, a second remote node 192, and a third remote node 193, each of which is in two-way communication with a central node 194. Note that in the system 190, the remote nodes are not able to communicate directly with one another. This is not essential to all example embodiments; one or more of the remote nodes may be able to communicate directly with one or more of the other remote nodes.

The flow charts below describe example uses of the principles discussed above.

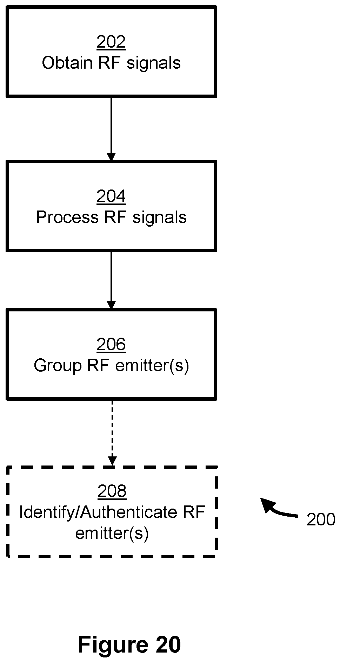

Figure 20 is a flow chart, indicated generally by the reference numeral 200, showing functionality in accordance with an example embodiment.

The flow chart 200 starts at step 202, where RF signals are obtained (e.g. received) at a first node of a system (e.g. a remote node, such as a satellite-based receiver located in space). The RF signals are transmitted by each of one or more (e.g. a plurality) of RF emitters. One or more of those emitters may be known to a model stored at (or available to) the first node.

At step 204 of the algorithm 200, the obtained RF signals are processed using a trained RF emitter profiling model (e.g. by generating an RF fingerprint for each respective RF emitter, as discussed in detail above). The RF emitter profiling model may be trained centrally (e.g. at a central node, such as a ground based node), but deployed locally (i.e. at the respective remote node).

At step 206 of the algorithm 200, the obtained RF signals are grouped, based on outputs of the RF emitter profiling model (e.g. based on RF fingerprints). Specifically, the obtained RF signals are grouped in one or more groups, wherein the RF signals within each group are deemed to originate from the same RF emitter.

Optionally, at step 208, the RF emitter of each group (or at least some of the groups) is identified. 10. Alternatively, or in addition, RF emitters may be authenticated, for example based on RF fingerprinting.

RF emitters that are grouped using the learnt emitter RF fingerprint, for example in accordance with the algorithm shown in the flow chart 200, can be used in a number of ways. For example, the positions of one or more RF emitters can be tracked, as discussed further below.

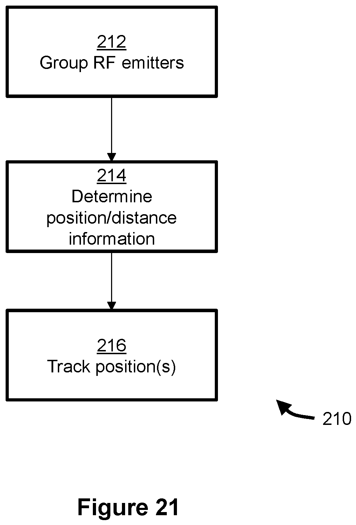

Figure 21 is a flow chart, indicated generally by the reference numeral 210, showing functionality in accordance with an example embodiment. The algorithm 210 starts at step 212, where RF emitters are grouped in one or more groups, wherein the RF signals within each group are deemed to originated from the same RF emitter. The step 212 may be implemented using the algorithm 200 described above.

The step 212 may be viewed as emitter data association (EDA) where RF emissions from the same emitter are grouped based on the extracted RF fingerprints from each emitter without the need to identify, thus only comparing the extracted RFFs from two or more emissions.

Step 214 of the flow chart 210 includes determining position or distance information for each of one or more RF emitters determined by said grouping. For example, relative positions of RF emitters could be determined, for example including determining distances between RF emitters.

At step 216, the position of one of more of the RF emitters (as determined in step 214) is tracked over time. In this way, RF emitter locations from similar RF emitters can be tracked, regardless of whether the identity of individual RF emitters in known.

As discussed further below, position or distance information as determined in step 214 may be provided to one or more other nodes of the system (e.g. one or more other remote nodes and/or a central node). Similarly, position or distance information for one of more RF emitters may be received from one or more other nodes of the system (e.g. one or more other remote nodes and/or a central node). By way of example, a distributed system may be provided that can determine (and track) the positions of many RF emitters; again, this can be done regardless of whether the identity of individual RF emitters is known.

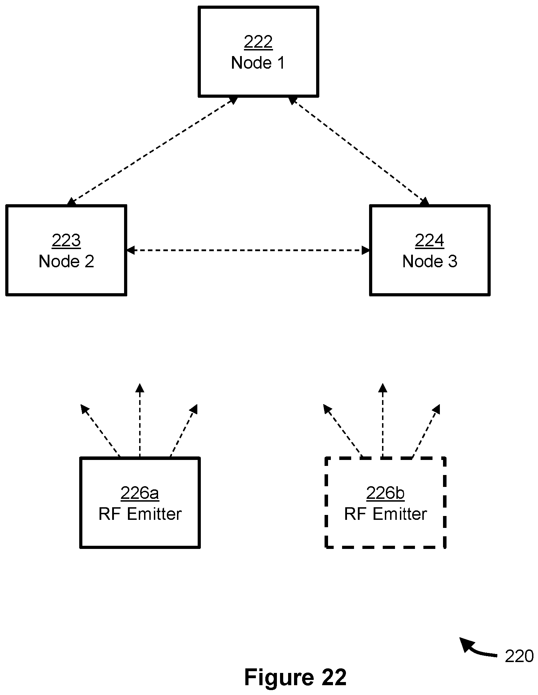

Figure 22 is a block diagram of a system, indicated generally by the reference numeral 220, in accordance with an example embodiment. The system 220 comprises a first node 222, a second node 223, a third node 224 and an RF emitter 226. The RF emitter moves from a first position 226a to a second position 226b.

RF signals emitted by the RF emitter 226 are detected at some or all of the nodes 222-224. The distance information can be shared between nodes such that geolocation can be carried out in order to determine the position of the RF emitter within the system 220.

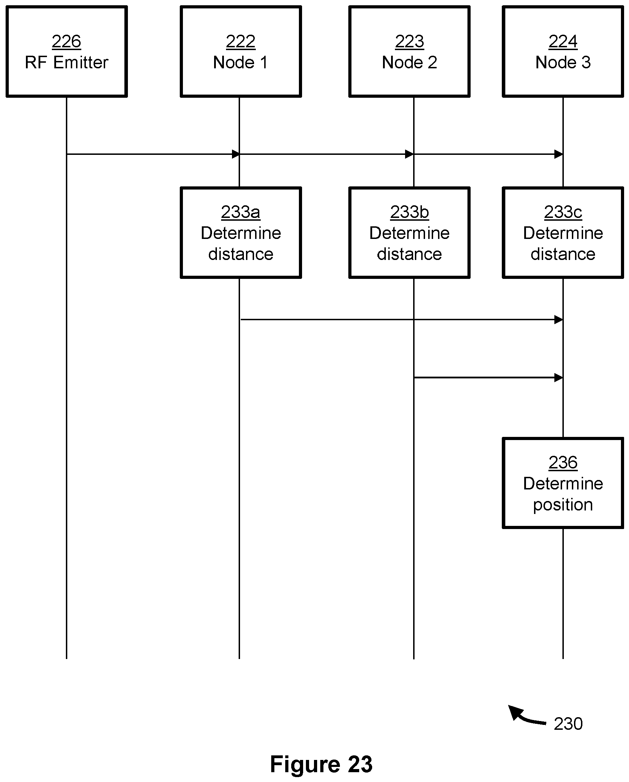

Figure 23 is a message flow sequence, indicated generally by the reference numeral 230, in accordance with an example embodiment. The sequence 230 shows messages transmitted between, and actions taken at, the nodes 222-224 and the RF emitter 226 of the system 220 described above.

As discussed above, RF signals emitted by the RF emitter 226 are detected at each of the nodes 222-224. At step 233a, the first node determines, based on the RF signals, a distance between the RF emitter and the first node 222. Similar determinations are made at step 233b (by the second node 223) and step 233c (at the third node 224).

Information relating to the determined distance is provided by the first and second nodes to the third node. In step 236, the third node uses this information to determine the position of the RF emitter 226 using geolocation.

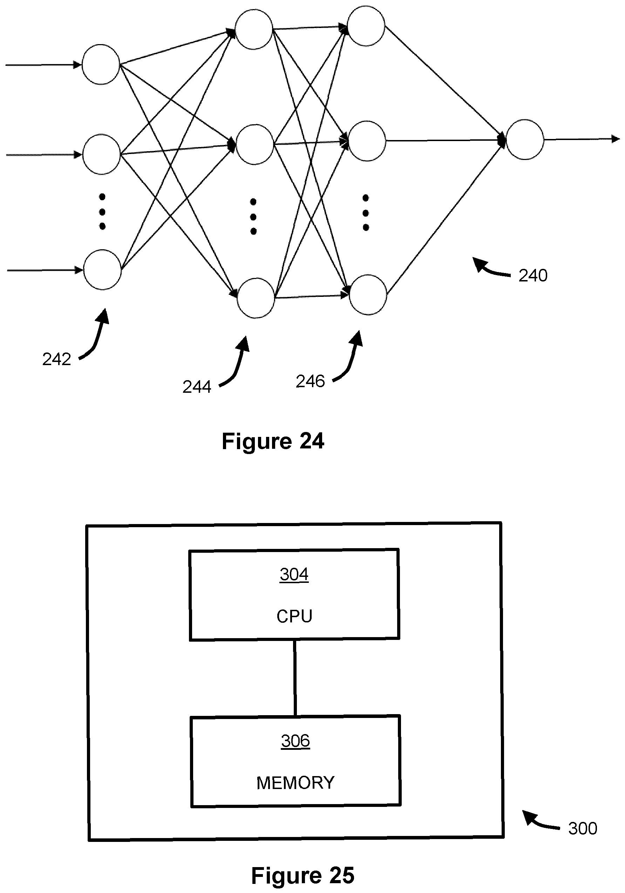

Figure 24 shows a neural network, indicated generally by the reference numeral 240, used in some example embodiments. For example, the neural network 240 may be used to implement the models 60 and 105 discussed above. The neural network 240 comprises a first layer 242, one or more hidden layers 244, and an output layer 246. Input data (such as RF data) may be provided to the first layer 242. Processed data, such as RF fingerprint data, may be output by the output layer 246.

Figure 25 shows a system 300 (comprising a memory 306 and processor 304) that can be used in implementations of example embodiments described herein. The processor 304 may store a computer program for implementing aspects of one or more of the algorithms described herein (such as the flow charts and message sequences 20, 90, 110, 120, 130, 140, 200, 210 or 230 described above). In practice, the processor 304 is likely to be a digital signal processor (DSP) including processing blocks such as multipliers, adder/subtractors, and storage registers. The processing may be performed in parallel using pipelines and local registers to enable a high processing rate and data throughput.

Embodiments of the components described herein can be implemented using any suitable software, hardware or firmware applications, programming language, data editors, etc., and may be represented/stored/processed using any suitable data structures, and so on.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A method comprising:
obtaining radio frequency, RF, data at a remote node of a system, wherein the RF data is transmitted by a RF emitter;
processing the obtained RF data at the remote node using a trained RF emitter profiling model to perform feature extraction;
determining whether the respective RF emitter is a known emitter;
providing data relating to the RF emitter to a central node of the system in the event that the RF emitter is not a known emitter; and
providing data relating to the RF emitter to a local database at the remote node in the event that the RF emitter is a known emitter.

2. The method of claim 1, further comprising receiving updates to the RF emitter profiling model, wherein said updates are in response, at least in part, to said data relating to the RF emitter provided to the central node, wherein the updates to the RF emitter profiling model optionally include updated weights of the model.

3. The method of any one of claims 1 to 2, wherein processing the obtained RF data comprises generating an RF fingerprint for the respective emitter.

4. The method of any one of claims 1 to 3, further comprising:
assigning an identifier to the RF emitter in the event that the RF emitter in not a known emitter, wherein the data provided to the central node includes said identifier.

5. The method of any one of claims 1 to 4, wherein the data relating to the RF emitter provided to the central node includes some or all of the obtained RF data.

6. The method of any one of claims 1 to 5, further comprising:
using a classifier to identify the RF emitter in the event that the RF emitter is a known emitter; and/or
updating the classifier based, at least in part, on the data relating to the RF emitter provided to said local database.

7. A method comprising:
receiving, at a central node of a system from a remote node of the system, data relating to an RF emitter that is not known to a RF emitter profiling model deployed at the remote node;
adding some or all of the received data to a training set for the RF emitter profiling model;
updating the RF emitter profiling model using said training set; and
providing an update to the RF emitter profiling model to the remote node.

8. The method of claim 7, wherein the update to the RF emitter profiling model provided to the remote node comprises updated weights of the RF emitter profiling model.

9. The method of claim 7 or claim 8, wherein:
the data relating to the RF emitter received at the central node includes an identifier to the RF emitter as assigned by the remote node; and
the received data added to said training data includes said identifier.

10. The method of any one of claims 7 to 9, wherein the RF emitter profile model is updated periodically.

11. The method of any one of claims 7 to 10, wherein the data relating to the RF emitter received at the central node from the remote node includes some or all of the RF data obtained by the remote node relating to said RF emitter.

12. The method of any one of claims 1 to 11, wherein:
the remote node is one of a plurality of remote nodes of the system; and/or
the remote node is satellite-based node.

13. A remote node of a system, the remote node comprising:
a first module for obtaining radio frequency, RF, data transmitted by a RF em itter;
a control module for processing the obtained RF data at the remote node using a trained RF emitter profiling model to perform feature extraction and to determine whether the respective RF emitter is a known emitter;
a local database for storing data relating to the RF emitter in the event that the RF emitter is a known emitter; and
a first output for providing data relating to the RF emitter to a central node of the system in the event that the RF emitter is not a known emitter.

14. A central node of a system, the central node comprising:
a first input for receiving, from a remote node of the system, data relating to an RF emitter that is not known to a RF emitter profiling model deployed at the remote node;
a control module for adding some or all of the received data to a training set for the RF emitter profiling model and updating the RF emitter profiling model using said training set; and
an output for providing an update to the RF emitter profiling model to the remote node.

15. A system comprising a central node as claimed in claim 14 and one or more remote nodes as claimed in claim 13.
